(19) Europäisches Patentamt
European Patent Office
Office européen des brevets

(11) **EP 3 176 953 B1**

(12) **FASCICULE DE BREVET EUROPEEN**

(45) Date de publication et mention
de la délivrance du brevet:
**03.07.2019 Bulletin 2019/27**

(51) Int Cl.:
*H03F 1/56* ^(2006.01)    *H03F 3/191* ^(2006.01)
*H03H 11/48* ^(2006.01)    *H04B 3/18* ^(2006.01)
*H03H 11/10* ^(2006.01)

(21) Numéro de dépôt: **16198604.7**

(22) Date de dépôt: **14.11.2016**

(54) **CIRCUIT D'IMPÉDANCE NÉGATIVE**

NEGATIVE IMPEDANZSCHALTUNG

NEGATIVE IMPEDANCE CIRCUIT

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **02.12.2015 FR 1561698**

(43) Date de publication de la demande:
**07.06.2017 Bulletin 2017/23**

(73) Titulaire: **COMMISSARIAT À L'ÉNERGIE
ATOMIQUE ET AUX
ÉNERGIES ALTERNATIVES
75015 Paris (FR)**

(72) Inventeurs:
- **Batel, Lotfi**
  **38000 Grenoble (FR)**
- **Pintos, Jean-François**
  **38140 Saint-Blaise-Du-Buis (FR)**
- **Rudant, Lionel**
  **38760 Varces Allières et Risset (FR)**

(74) Mandataire: **Cabinet Beaumont
4, Place Robert Schuman
B.P. 1529
38025 Grenoble Cedex 1 (FR)**

(56) Documents cités:
**US-A- 3 042 759    US-A- 3 204 048
US-A- 4 056 688    US-A- 4 112 262**

EP 3 176 953 B1

**Description**

<u>Domaine</u>

La présente description concerne de façon générale les systèmes électroniques et, plus particulièrement, la réalisation d'un circuit ou convertisseur d'impédance négative. La présente description concerne plus précisément les convertisseurs d'impédance négative destinés à des chaines d'émission-réception radiofréquence.

<u>Exposé de l'art antérieur</u>

Dans la quasi-totalité des systèmes électroniques, et plus particulièrement dans les chaines radiofréquence (émission et/ou réception), on utilise des circuits d'adaptation d'impédance. De tels circuits, en entrée et/ou en sortie d'éléments d'une chaine radiofréquence sont indispensables pour garantir une transmission correcte (sans trop de pertes). En fonction des caractéristiques des éléments à connecter, on peut avoir besoin de générer une impédance négative afin de respecter une valeur d'impédance de référence (par exemple 50 ohms, 75 ohms, 100 ohms, etc.).

La plupart des circuits de génération d'une impédance négative doivent être dédiés à une bande de fréquences de fonctionnement et cette bande de fréquences est relativement étroite. Or, de plus en plus, les systèmes de transmission radiofréquence doivent être à large bande.

Il existe un besoin d'améliorer les circuits présentant une impédance négative, en particulier à des fins d'adaptation d'impédance.

Il existe également un besoin de disposer d'une impédance négative à large bande.

Le document US3204048 décrit un exemple de circuit d'impédance négative à base de transistors bipolaires.

<u>Résumé</u>

Un mode de réalisation est défini par la revendication indépendante 1 et pallie tout ou partie des inconvénients des circuits d'impédance négative. Le mode de réalisation propose une solution large bande. Le mode de réalisation propose une solution particulièrement adaptée aux chaines de transmission radiofréquence.

Ainsi, un exemple prévoit un circuit d'impédance négative comportant : un premier et un deuxième transistors bipolaires à collecteur commun, une base du premier transistor étant connectée à un émetteur du deuxième transistor ; un troisième et un quatrième transistors bipolaires à collecteur commun, une base du troisième transistor étant connectée à un émetteur du quatrième transistor ; et au moins une première impédance constituée d'un ou plusieurs composants passifs couplant le collecteur commun des premier et deuxième transistors au collecteur commun des troisième et quatrième transistors, une base du deuxième transistor étant couplée au collecteur des troisième et quatrième transistors et une base du quatrième transistor étant couplée au collecteur des premier et deuxième transistors.

Selon un mode de réalisation, ladite première impédance est au moins inductive ou capacitive.

Selon un exemple, une deuxième impédance, constituée d'un ou plusieurs composants passifs, relie les bases des premier et troisième transistors.

Selon un exemple, ladite deuxième impédance est au moins inductive ou capacitive.

Selon un mode de réalisation, les émetteurs des premier et troisième transistors sont respectivement reliés à des bornes du circuit.

Selon un exemple, la liaison entre les émetteurs respectifs des premier et troisième transistors et lesdites bornes s'effectue par l'intermédiaire d'éléments capacitifs de découplage.

Selon un exemple, des éléments capacitifs relient respectivement la base du deuxième transistor au collecteur commun des troisième et quatrième transistors et la base du quatrième transistor au collecteur commun des premier et deuxième transistors.

Selon un mode de réalisation, des éléments résistifs de polarisation relient individuellement les collecteurs communs des premier et deuxième transistors et les bases des troisième et quatrième transistors à une borne d'application d'un potentiel de polarisation.

Selon un mode de réalisation, les transistors sont de type PNP.

Selon un mode de réalisation, les transistors sont de type NPN.

<u>Brève description des dessins</u>

Ces caractéristiques et avantages, ainsi que d'autres, seront exposés en détail dans la description suivante de modes de réalisation particuliers faite à titre non limitatif en relation avec les figures jointes parmi lesquelles :

la figure 1 est un schéma-bloc simplifié d'un exemple de chaine de transmission radiofréquence du type auquel s'appliquent les modes de réalisation décrits ;

la figure 2 est un schéma électrique d'un exemple connu d'impédance négative ;

la figure 2A représente un schéma équivalent radiofréquence du montage de la figure 2 ;

la figure 3 est un schéma électrique d'un mode de réalisation d'un circuit d'impédance négative ;

la figure 4 est un schéma électrique d'un autre mode de réalisation d'un circuit d'impédance négative ;

la figure 5 représente l'équivalent du circuit d'impédance négative de la figure 4 sans éléments de polarisation ou de découplage ; et

les figures 6A, 6B, 6C, 6D et 6E illustrent des exemples d'impédances passives constituant des éléments des circuits des figures 3 à 5.

Description détaillée

Par souci de clarté, seuls les éléments qui sont utiles à la compréhension des modes de réalisation décrits ont été représentés et seront détaillés. En particulier, l'utilisation d'un circuit d'impédance négative n'a pas été détaillée, les modes de réalisation décrits étant compatibles avec les utilisations usuelles de tels circuits. Il est à noter que, sur les figures, les éléments structurels et/ou fonctionnels communs aux différents modes de réalisation peuvent présenter les mêmes références et peuvent disposer de propriétés structurelles, dimensionnelles et matérielles identiques. Sauf précision contraire, les expressions "approximativement", "sensiblement" et "de l'ordre de" signifient à 10 % près, de préférence à 5 % près. Dans la description qui suit, la notion de couplage entre deux éléments est utilisée pour désigner une liaison directe ou indirecte (par l'intermédiaire d'éléments passifs) entre deux constituants alors que la notion de connexion est utilisée pour spécifier une liaison directe, sans composant intermédiaire.

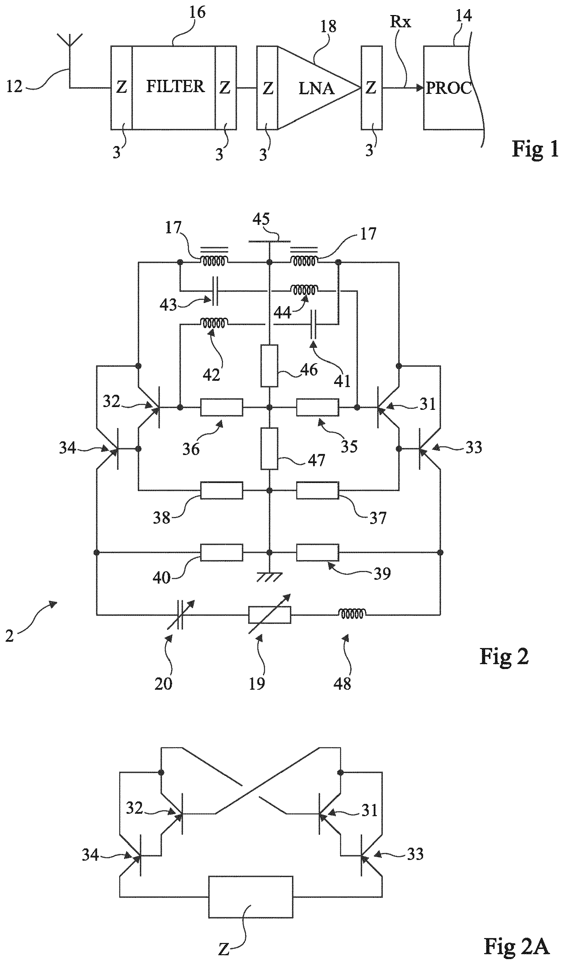

La figure 1 est un schéma-bloc simplifié d'un exemple de chaine de transmission radiofréquence du type auquel s'appliquent les modes de réalisation décrits.

Un telle chaine de transmission comporte plusieurs éléments en série entre une antenne 12 et un circuit 14 (PROC) de traitement des informations reçues ou à transmettre. Par exemple, l'antenne 12 est reliée à un filtre 16 (FILTER), principalement chargé d'éliminer les signaux hors bande de transmission, lui-même relié à un amplificateur à faible bruit 18 (LNA) des signaux reçus qui sont transmis (Rx) au circuit de traitement 14. L'exemple ci-dessus considère le cas d'une réception. En émission, le système peut ou non utiliser la même antenne et comporte généralement un amplificateur entre le circuit de traitement 14 et l'antenne 12 (avec interposition éventuelle d'un filtre d'émission).

Afin de respecter une adaptation d'impédance entre les différents constituants de la chaine radiofréquence, des circuits 3 d'adaptation d'impédance (Z) sont généralement prévus en entrée et en sortie de chaque constituant de la chaine. Dans certains cas, on peut avoir besoin, selon la structure des circuits, d'impédances négatives pour réaliser cette adaptation.

L'exemple de la figure 1 est un exemple choisi arbitrairement et les modes de réalisation qui sont décrits ci-après s'appliquent plus généralement à toute chaine de transmission radiofréquence et encore plus généralement à toute application dans laquelle on souhaite exploiter une impédance négative, par exemple des applications de communication sans contact, des transmissions radio intégrées, des têtes de transmission radiofréquence, etc.

La figure 2 est un schéma électrique d'un exemple de circuit 2 générant une résistance négative. Cet exemple correspond à la solution décrite dans le document US-B-3,204,048.

Ce circuit 2 est basé sur l'utilisation de deux paires de transistors PNP, respectivement 31, 33 et 32, 34. Les émetteurs des transistors 33 et 34 sont connectés ensemble via une association série d'un circuit RLC formé d'une inductance 48, d'une résistance ajustable 19 et d'une capacité ajustable 20. Les bases des transistors 33 et 34 sont connectées aux émetteurs respectifs des transistors 31 et 32. Les collecteurs des transistors 31 et 33 sont interconnectés. Les collecteurs des transistors 32 et 34 sont interconnectés. La base du transistor 31 est reliée, par une inductance 44 en série avec une capacité 43, au collecteur commun des transistors 32 et 34. La base du transistor 32 est reliée, par une inductance 42 en série avec une capacité 41, au collecteur commun des transistors 31 et 33. Les bases des transistors 31 et 32 sont reliées ensemble par une association en série de résistances 35 et 36 dont le point milieu est relié par des résistances 46 et 47, respectivement à une borne 45 d'application d'un potentiel positif et à la masse. Les émetteurs des transistors 33 et 34 sont chacun reliés à la masse par une résistance, respectivement 39, 40. Les bases des transistors 33 et 34 (émetteurs des transistors 31 et 32) sont chacune reliées à la masse par une résistance, respectivement 37, 38. Les bornes de la résistance négative 2 sont les collecteurs des transistors 31 et 32 qui sont reliées à des inductances 17 d'un transformateur.

La figure 2A représente un schéma équivalent radiofréquence du montage de la figure 2, c'est-à-dire sans les éléments de polarisation et de découplage.

Le schéma se ramène à quatre transistors associés deux à deux en montage Darlington, une impédance Z reliant l'émetteur du transistor 33 à l'émetteur du transistor 34.

Une telle solution de génération d'une résistance négative n'est cependant pas transposable à la réalisation d'une impédance négative complexe. Or, dans les applications visées par la présente description, il est souvent nécessaire de disposer d'impédances d'adaptation complexes et pas uniquement résistives.

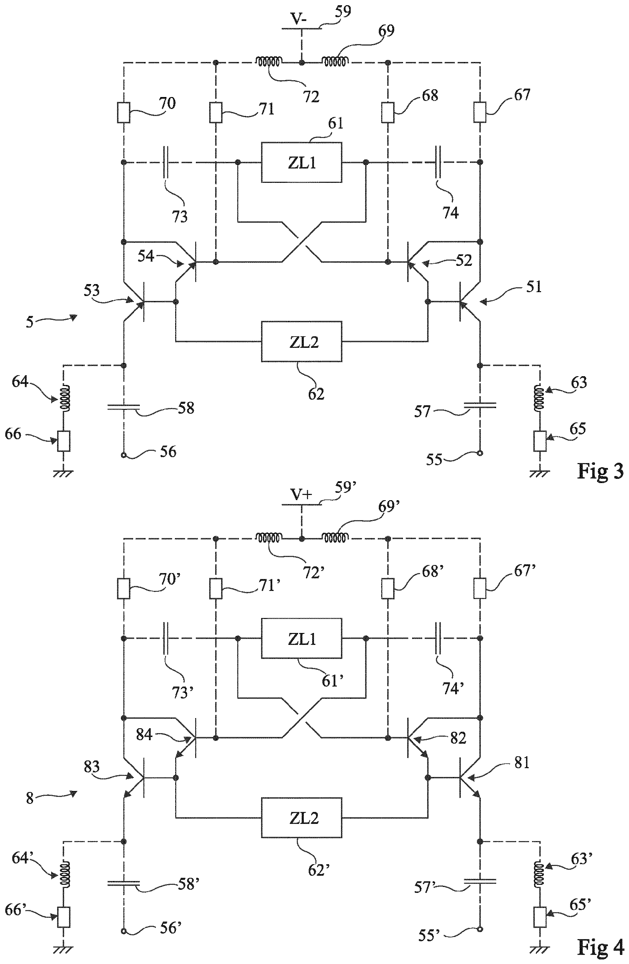

La figure 3 est un schéma électrique d'un mode de réalisation d'un circuit 5 d'impédance négative basé sur des transistors bipolaires de type PNP.

Ce circuit 5 est basé sur l'utilisation de deux paires de transistors PNP, respectivement 51, 52 et 53, 54. Les émetteurs des transistors 51 et 53 sont respectivement couplés à des bornes 55 et 56 de l'impédance négative réalisée. Ces bornes 55 et 56 sont destinées à être connectées à l'élément dont on souhaite adapter l'impédance d'entrée et/ou de sortie. De préférence, un élément capacitif, respectivement 57 ou 58, de découplage d'une éventuelle composante continue du signal, est intercalé entre l'émetteur du transistor 51 ou 53 et la borne respective 55 ou 56. Les bases respectives des transistors 51 et 53 sont connectées aux émetteurs respectifs des transistors 52 et 54. Par ailleurs, les collecteurs des transistors 51 et 52 sont interconnectés et les collecteurs des transistors 53 et 54 sont interconnectés.

Pour réaliser une impédance négative, les bases des transistors 52 et 54 sont couplées par une première impédance 61 (ZL1) constituée de composants passifs. De préférence, afin de procurer un degré de liberté (de réglage) supplémentaire, les émetteurs des transistors 52 et 54 sont couplés par une deuxième impédance 62 (ZL2) constituée de composants passifs. On tire profit de la structure en paire des transistors 51, 52 et 53, 54 pour incorporer un chemin radiofréquence supplémentaire formé par l'impédance 62.

La polarisation du circuit 5 est assurée par des éléments résistifs, capacitifs et inductifs. Par exemple, les émetteurs des transistors 51 et 53 sont respectivement couplés à la masse par des associations en série d'éléments inductifs 63, respectivement 64 et résistifs 65, respectivement 66. Toujours à titre d'exemple, le collecteur commun des transistors 51 et 52 et la base du transistor 52 sont connectés, par des éléments résistifs, respectivement 67 et 68, à un élément inductif 69 de connexion à une borne 59 d'application d'un potentiel V- négatif par rapport à la masse. Par ailleurs, le collecteur commun des transistors 53 et 54 et la base du transistor 54 sont connectés, par des éléments résistifs, respectivement 70 et 71, à un élément inductif 72 de connexion à la borne 59. En outre, la base du transistor 52 est couplée, par un élément capacitif 73, au collecteur commun des transistors 53 et 54, et la base du transistor 54 est couplée, par un élément capacitif 74, au collecteur commun des transistors 51 et 52. On peut également dire que l'impédance passive 61 couple les collecteurs des paires de transistors.

Pour faire ressortir la fonction de polarisation ou de découplage des éléments 57 à 59 et 63 à 74, leurs connexions respectives ont été illustrées en pointillés.

La figure 4 est un schéma électrique d'un autre mode de réalisation d'un circuit 8 d'impédance négative, basé sur des transistors bipolaires de type NPN.

Ce circuit 8 est basé sur l'utilisation de deux paires de transistors NPN, respectivement 81, 82 et 83, 84. Les émetteurs des transistors 81 et 83 sont respectivement couplés à des bornes 55' et 56' de l'impédance négative réalisée. Ces bornes 55' et 56' sont destinées à être connectées à l'élément dont on souhaite adapter l'impédance d'entrée et/ou de sortie. De préférence, un élément capacitif, respectivement 57' ou 58', de découplage d'une éventuelle composante continue du signal, est intercalé entre l'émetteur du transistor 81 ou 83 et la borne respective 55' ou 56'. Les bases respectives des transistors 81 et 83 sont connectées aux émetteurs respectifs des transistors 82 et 84. Par ailleurs, les collecteurs des transistors 81 et 82 sont interconnectés et les collecteurs des transistors 83 et 84 sont interconnectés.

Pour réaliser l'impédance négative, les bases des transistors 82 et 84 sont couplées par une première impédance 61' (ZL1) constituée de composants passifs. Comme dans le mode de réalisation de la figure 3, afin de procurer un degré de liberté supplémentaire, les émetteurs des transistors 82 et 84 sont, de préférence, couplés par une deuxième impédance 62' (ZL2) constituée de composants passifs.

La polarisation du circuit 8 est assurée par des éléments résistifs, capacitifs et inductifs similaires ou identiques à ceux décrits en relation avec la figure 3, à la différence près que la polarisation des collecteurs des transistors 81, 82, 83, 84 et des bases des transistors 82 et 84 est effectuée à partir d'un potentiel positif par rapport à la masse. Ainsi, à titre d'exemple, les émetteurs des transistors 81 et 83 sont respectivement couplés à la masse par des associations en série d'éléments inductifs 63', respectivement 64' et résistifs 65', respectivement 66'. Toujours à titre d'exemple, les collecteurs communs des transistors 81 et 82 et la base du transistor 82 sont connectés, par des éléments résistifs, respectivement 67' et 68', à un élément inductif 69' de connexion à une borne 59' d'application d'un potentiel V+ positif par rapport à la masse. Par ailleurs, les collecteurs communs des transistors 83 et 84 et la base du transistor 84 sont connectés, par des éléments résistifs, respectivement 70' et 71', à un élément inductif 72' de connexion à la borne 59'. En outre, la base du transistor 82 est couplée, par un élément capacitif 73', au collecteur commun des transistors 83 et 84, et la base du transistor 84 est couplée, par un élément capacitif 74', au collecteur commun des transistors 81 et 82.

Là encore, pour faire ressortir la fonction de polarisation ou de découplage des éléments 57' à 59' et 63' à 74', leurs connexions respectives ont été illustrées en pointillés.

Les impédances 61 et 62 (figure 3) ou 61' et 62' (figure 4) sont, de préférence, des impédances au moins inductives et/ou capacitives et, de préférence, des impédances résistives, inductives et capacitives. Ces impédances sont des impédances série ou parallèle en montage de type PI ou T. Il ne s'agit donc pas d'éléments de polarisation des transistors. Chaque impédance ZL1, ZL2 se présente sous la forme d'un quadripôle dont les bornes d'accès sont raccordées aux bases et aux émetteurs des transistors 82 et 84 (52 et 54 dans le cas de la figure 3).

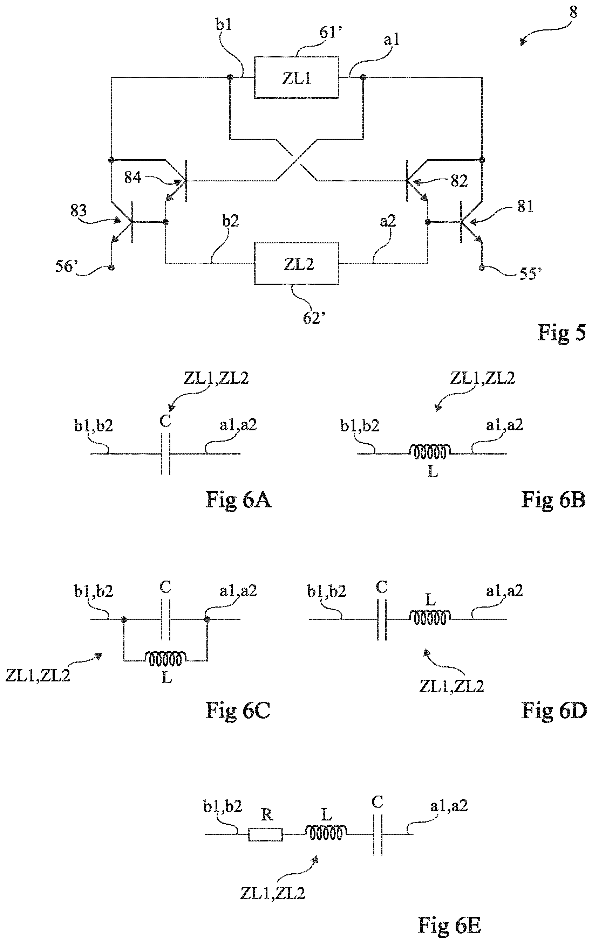

La figure 5 représente l'équivalent du circuit 8 d'impédance négative de la figure 4 sans les éléments de polarisation ou de découplage. Cela revient à ne considérer que le comportement radiofréquence du circuit. Les fréquences radio plus particulièrement visées par la présente description sont supérieures à 10 MHz.

Pour le comportement radiofréquence, on ne tient pas compte des éléments 57' à 59' et 63' à 74' de la figure 4. Les émetteurs des transistors 81 et 83 sont alors reliés aux bornes 55' et 56'. Le collecteur commun des transistors 81 et 82 est relié à une première borne a1 de l'impédance 61' et à la base du transistor 84. Le collecteur commun des transistors 83 et 84 est relié à une deuxième borne b1 de l'impédance 61' et à la base du transistor 82. Les bases des transistors 81 et 83, respectivement confondues avec les émetteurs des transistors 82 et 84 sont toujours couplées par l'impédance 62'. Le schéma de la figure 5 fait mieux ressortir la boucle de rétroaction formée entre les paires de transistors par l'intermédiaire de l'impédance 61'.

En prenant l'exemple de la figure 5, et en supposant que tous les transistors sont identiques, de gain $\beta$ et de résistance d'entrée $h_{11}$, la fonction de transformation d'impédance Z du circuit 8 peut s'écrire :

$$Z = -\frac{\beta^4}{1 + \beta} \cdot ZL + \frac{h_{11}}{1 + \beta}\left(1 + \frac{\beta^2 + 5 \cdot \beta + 2}{\beta \cdot (1 + \beta)}\right),$$

avec :

$$ZL = ZL1 \frac{ZL1 - ZL2 - \frac{h_{11}}{\beta}}{ZL1 + ZL2 \cdot (1 - \beta^2) + h_{11} \cdot (1 - \beta)}.$$

On voit que l'impédance Z obtenue entre les bornes 55' et 56' dépend d'une charge virtuelle ZL dont le signe du coefficient directeur est négatif. Cependant, la charge ZL dépend essentiellement des valeurs des impédances passives (positives) ZL1 et ZL2. Ainsi, en faisant varier les valeurs des impédances ZL1 et ZL2 (des composants résistifs, capacitifs et inductifs qui les composent), on peut faire varier la valeur de l'impédance négative obtenue. Dans le mode de réalisation préféré où l'on utilise une impédance ZL2, on accroît la gamme de valeurs possibles de l'impédance négative résultante. De préférence, au moins certains des composants passifs constituant les impédances ZL1 et ZL2 sont des composants de valeur ajustable afin d'accroitre les possibilités de réglage dans l'application.

Les figures 6A, 6B, 6C, 6D et 6E illustrent des exemples d'impédances passives pouvant être choisies pour former les impédances ZL1 et ZL2 des circuits des figures 3 à 5.

La figure 6A illustre le cas d'une impédance passive constituée d'un élément capacitif C entre les bornes a1 et b1, respectivement a2 et b2.

La figure 6B illustre le cas d'une impédance passive constituée d'un élément inductif L entre les bornes a1 et b1, respectivement a2 et b2.

La figure 6C illustre le cas d'une impédance passive sous la forme d'un circuit LC parallèle, constitué d'un élément capacitif C en parallèle avec un élément inductif L, entre les bornes a1 et b1, respectivement a2 et b2.

La figure 6D illustre le cas d'une impédance passive sous la forme d'un circuit LC série, constitué d'un élément capacitif C en série avec un élément inductif L, entre les bornes a1 et b1, respectivement a2 et b2.

La figure 6E illustre le cas d'une impédance passive sous la forme d'un circuit RLC série constitué d'éléments résistif R, capacitif C et inductif L, en série entre les bornes a1 et b1, respectivement a2 et b2. La représentation de la figure 6E constitue par ailleurs la représentation équivalente (circuit RLC série) de toute réalisation d'impédance passive utilisable pour constituer les impédances ZL1 et ZL2.

Le type d'impédance passive peut être différent pour l'impédance ZL1 et pour l'impédance ZL2 dans un même circuit, c'est-à-dire par exemple que l'impédance ZL1 peut être principalement capacitive et l'impédance ZL2 principalement inductive, ou inversement.

Un avantage des réalisations décrites est qu'elles permettent de réaliser des impédances négatives en utilisant des composants passifs de valeurs compatibles avec des gammes de fréquences radio. Chaque circuit 3 de la figure 1 peut, par exemple, être formé d'un circuit 5 et 8.

On notera que, que ce soit avec une réalisation à base de transistors PNP ou de transistors NPN, les collecteurs des transistors de chaque paire sont communs et les bornes d'accès 55, 56 ou 55', 56' du dipôle d'impédance négative obtenu, sont côté émetteur des transistors.

Divers modes de réalisation ont été décrits. Diverses variantes et modifications apparaîtront à l'homme de l'art. En particulier, le choix des valeurs des impédances ZL1 et ZL2 dépend de l'application et de la gamme de valeurs d'impédances négatives souhaitée. De même, les valeurs données aux composants de polarisation dépendent de l'application. En outre, la mise en oeuvre pratique des modes de réalisation qui ont été décrits est à la portée de l'homme de métier à partir des indications fonctionnelles données ci-dessus.

**Revendications**

1. Circuit d'impédance négative comportant :

   un premier (51 ; 81) et un deuxième (52 ; 82) transistors bipolaires à collecteur commun, une base du premier transistor étant connectée à un émetteur du deuxième transistor ;
   un troisième (53 ; 83) et un quatrième (54 ; 84) transistors bipolaires à collecteur commun, une base du troisième transistor étant connectée à un émetteur du quatrième transistor ;
   au moins une première impédance (61 ; 61') constituée d'un ou plusieurs composants passifs (R, L, C) couplant le collecteur commun des premier et deuxième transistors au collecteur commun des troisième et quatrième transistors, une base du deuxième transistor étant couplée, par un élément capacitif (73 ; 73'), au collecteur des troisième et quatrième transistors et une base du quatrième transistor étant couplée, par un élément capacitif (74 ; 74'), au collecteur des premier et deuxième transistors ; et **caractérisé en ce que**
   une deuxième impédance (62 ; 62') au moins inductive ou capacitive, constituée d'un ou plusieurs composants passifs (R, L, C), connecte directement entre elles les bases des premier (51 ; 81) et troisième (53 ; 83) transistors.

2. Circuit selon la revendication 1, dans lequel ladite première impédance (61 ; 61') est au moins inductive ou capacitive.

3. Circuit selon l'une quelconque des revendications 1 ou 2, dans lequel les émetteurs des premier (51 ; 81) et troisième (53 ; 83) transistors sont respectivement reliés à des bornes (55, 56 ; 55', 56') du circuit.

4. Circuit selon la revendication 3, dans lequel la liaison entre les émetteurs respectifs des premier (51 ; 81) et troisième (53 ; 83) transistors et lesdites bornes (55, 56 ; 55', 56') s'effectue par l'intermédiaire d'éléments capacitifs (57, 58 ; 57', 58') de découplage.

5. Circuit selon l'une quelconque des revendications 1 à 4, dans lequel des éléments résistifs de polarisation (67, 68, 70, 71 ; 67', 68', 70', 71') relient individuellement les collecteurs communs des premier (51 ; 81) et deuxième (52 ; 82) transistors et les bases des deuxième (52 ; 82) et quatrième transistors (54 ; 84) à une borne (59 ; 59') d'application d'un potentiel de polarisation.

6. Circuit selon l'une quelconque des revendications 1 à 5, dans lequel les transistors (51, 52, 53, 54) sont de type PNP.

7. Circuit selon l'une quelconque des revendications 1 à 5, dans lequel les transistors (81, 82, 83, 84) sont de type NPN.

**Patentansprüche**

1. Eine Schaltung mit negativer Impedanz, die Folgendes aufweist:

   einen ersten (51; 81) und einen zweiten (52; 82) bipolaren Transistor mit einem gemeinsamen Kollektor, wobei eine Basis des ersten Transistors mit einem Emitter des zweiten Transistors verbunden ist;
   einen dritten (53; 83) und einen vierten (54; 84) bipolaren Transistor mit einem gemeinsamen Kollektor, wobei eine Basis des dritten Transistors mit einem Emitter des vierten Transistors verbunden ist;
   wenigstens eine erste Impedanz (61; 61'), die aus einer oder mehreren passiven Komponente/n (R, L, C) ausgebildet ist, die den gemeinsamen Kollektor des ersten und zweiten Transistors mit dem gemeinsamen Kollektor des dritten und vierten Transistors koppeln, wobei eine Basis des zweiten Transistors über ein kapazitives Element (73; 73') mit dem Kollektor des dritten und vierten Transistors gekoppelt ist, und eine Basis des vierten Transistors über ein kapazitives Element (74; 74') mit dem Kollektor des ersten und zweiten Transistors gekoppelt ist, **dadurch gekennzeichnet, dass**
   eine zweite Impedanz (62; 62'), die wenigstens induktiv oder kapazitiv ist und aus einer oder mehreren passiven Komponente/n (R, L, C) ausgebildet ist, die Basen der ersten (51; 81) und dritten (53; 83) Transistoren direkt verbindet.

**2.** Die Schaltung nach Anspruch 1, wobei die erste Impedanz (61; 61') wenigstens induktiv oder kapazitiv ist.

**3.** Schaltung nach einem der Ansprüche 1 oder 2, wobei die Emitter der ersten (51; 81) und dritten (53; 83) Transistoren jeweils mit den Anschlüssen (55, 56; 55', 56') der Schaltung verbunden sind.

**4.** Die Schaltung nach Anspruch 3, wobei die Verbindung zwischen den jeweiligen Emittern der ersten (51; 81) und dritten (53; 83) Transistoren und den Anschlüssen (55, 56; 55', 56') über kapazitive Entkopplungselemente (57, 58; 57', 58') durchgeführt wird.

**5.** Die Schaltung nach einem der Ansprüche 1 bis 4, wobei resistive Vorspannelemente (67, 68, 70, 71; 67', 68', 70', 71') die gemeinsamen Kollektoren der ersten (51; 81) und zweiten (52; 82) Transistoren und die Basen der zweiten (52; 82) und vierten (54; 84) Transistoren mit einem Anschluss (59; 59') zum Anlegen einer Vorspannung individuell verbinden.

**6.** Schaltung nach einem der Ansprüche 1 bis 5, wobei die Transistoren (51, 52, 53, 54) vom PNP-Typ sind.

**7.** Schaltung nach einem der Ansprüche 1 bis 5, wobei die Transistoren (81, 82, 83, 84) vom NPN-Typ sind.

**Claims**

**1.** A negative impedance circuit, comprising:

a first (51; 81) and a second (52; 82) bipolar transistors having a common collector, a base of the first transistor being connected to an emitter of the second transistor;
a third (53; 83) and a fourth (54; 84) bipolar transistors having a common collector, a base of the third transistor being connected to an emitter of the fourth transistor;
at least one first impedance (61; 61') formed of one or of a plurality of passive components (R, L, C) coupling the common collector of the first and second transistors to the common collector of the third and fourth transistors, a base of the second transistor being coupled, by a capacitive element (73 ; 73'), to the collector of the third and fourth transistors and a base of the fourth transistor being coupled, by a capacitive element (74 ; 74'), to the collector of the first and second transistors, **characterized in that**
a second impedance (62; 62') at least inductive or capacitive, formed of one or a plurality of passive components (R, L, C), directly connects the bases of the first (51; 81) and third (53; 83) transistors.

**2.** The circuit of claim 1, wherein said first impedance (61; 61') is at least inductive or capacitive.

**3.** The circuit of any of claims 1 or 2, wherein the emitters of the first (51; 81) and third (53; 83) transistors are respectively connected to terminals (55, 56; 55', 56') of the circuit.

**4.** The circuit of claim 3, wherein the connection between the respective emitters of the first (51; 81) and third (53; 83) transistors and said terminals (55, 56; 55', 56') is performed via capacitive decoupling elements (57, 58; 57', 58').

**5.** The circuit of any of claims 1 to 4, wherein resistive biasing elements (67, 68, 70, 71; 67', 68', 70', 71') individually connect the common collectors of the first (51; 81) and second (52; 82) transistors and the bases of the second (52; 82) and fourth (54; 84) transistors to a terminal (59; 59') of application of a bias voltage.

**6.** The circuit of any of claims 1 to 5, wherein the transistors (51, 52, 53, 54) are of PNP type.

**7.** The circuit of any of claims 1 to 5, wherein the transistors (81, 82, 83, 84) are of NPN type.

Fig 1

Fig 2

Fig 2A

**Fig 3**

**Fig 4**

Fig 5

Fig 6A

Fig 6B

Fig 6C

Fig 6D

Fig 6E

## RÉFÉRENCES CITÉES DANS LA DESCRIPTION

**Documents brevets cités dans la description**

- US 3204048 A

- US 3204048 B